# EUROPEAN PATENT APPLICATION

(11) **EP 4 668 483 A1**
(43) Date of publication of application: **24.12.2025**
(21) Application number: 24744430.0
(22) Date of filing: 29.02.2024
(51) Int. Cl.: H01Q 1/52

(54) **MIDDLE FRAME ASSEMBLY, FOLDABLE DISPLAY MODULE, AND FOLDABLE DISPLAY DEVICE**

(71) Applicant: Huawei Technologies Co., Ltd., Shenzhen, Guangdong 518129 (CN)
(72) Inventor: WANG, Lei, Shenzhen, Guangdong 518129 (CN); ZHA, Peng, Shenzhen, Guangdong 518129 (CN); PANG, Dong, Shenzhen, Guangdong 518129 (CN); HUANG, Bo, Shenzhen, Guangdong 518129 (CN)
(74) Representative: MERH-IP Matias Erny Reichl Hoffmann Patentanwälte PartG mbB
(86) International application number: PCT/CN2024/079472
(87) International publication number: WO 2024/153261

(57) **Abstract**

Embodiments of this application disclose a middle frame assembly, a foldable display module, and a foldable display device, and relate to the field of foldable screens, to reduce a loss of an antenna. A specific solution is as follows: In a foldable screen device with three or more folds, a baffle is disposed between an antenna and a flexible printed circuit board, and the baffle is electrically connected to a middle frame, so that an electromagnetic wave emitted by the antenna to the flexible printed circuit board is blocked by the baffle. Alternatively, a shield layer is disposed on a surface of the flexible printed circuit board, and the shield layer is electrically connected to the middle frame, so that the electromagnetic wave emitted by the antenna to the flexible printed circuit board is shielded by the shield layer. Therefore, after the foldable screen device is folded, an electromagnetic wave signal that passes through the flexible printed circuit board is blocked, and few electromagnetic wave signals can reach a light emitting layer in a display panel and then be absorbed. This resolves a problem of a signal loss of the antenna.

## Description

This application claims priority to Chinese Patent Application No. 202310104021.7, filed with the China National Intellectual Property Administration on January 16, 2023 and entitled "MIDDLE FRAME ASSEMBLY, FOLDABLE DISPLAY MODULE, AND FOLDABLE DISPLAY DEVICE", which is incorporated herein by reference in its entirety.

### TECHNICAL FIELD

Embodiments of this application relate to the field of foldable screens, and in particular, to a middle frame assembly, a foldable display module, and a foldable display device.

### BACKGROUND

With development of electronic devices, large-screen electronic devices occupy an increasing share in a consumer market, and foldable electronic devices receive more attention in the market. As a result, costs invested by manufacturers in the foldable electronic devices also increase. An electromagnetic environment of the foldable electronic device is very complex, and the complex electromagnetic environment brings a great challenge to scientific researchers. For example, how to reduce a signal loss of a multi-fold mobile phone screen becomes a major problem that bothers the scientific researchers.

### SUMMARY

Embodiments of this application provide a middle frame assembly, a foldable display module, and a foldable display device, to resolve a problem of a signal loss of an antenna due to absorption of an antenna signal when a display panel is in a folded state.

To achieve the foregoing objective, this application uses the following technical solutions.

According to a first aspect, a foldable display module is provided, including a display panel, a flexible printed circuit board, a middle frame, an antenna, and a baffle. The display panel is able to be folded in an S shape. The middle frame is connected to one side of the display panel. The display panel and the flexible printed circuit board are arranged in a preset direction. The antenna is connected to the display panel. The middle frame includes at least three sub-frames that are arranged in the preset direction and rotatably connected in sequence, and a sub-frame that is of the at least three sub-frames and that is closest to the flexible printed circuit board is a first sub-frame. The baffle is connected to one end that is of the first sub-frame and that is close to the flexible printed circuit board. The baffle is electrically connected to the end that is of the first sub-frame and that is close to the flexible printed circuit board. The antenna and the flexible printed circuit board are respectively located on two opposite sides of the baffle, and an outer contour of a projection of the baffle in a region of the antenna at least partially covers a projection of the flexible printed circuit board in the region of the antenna. An electromagnetic wave signal emitted by the antenna toward the flexible printed circuit board passes through the flexible printed circuit board. After the display panel is folded in the S shape, the electromagnetic wave signal that passes through the flexible printed circuit board is absorbed by the display panel, causing a signal loss of the antenna. The baffle may block the electromagnetic wave signal emitted by the antenna toward the flexible printed circuit board, and weaken the electromagnetic wave signal that passes through the flexible printed circuit board, so that the signal absorbed by the display panel is reduced, and the signal loss of the antenna is effectively improved. In addition, the baffle is electrically connected to the first sub-frame, and the baffle can prevent static electricity from passing through the baffle and being conducted to the display panel, thereby resolving a problem that static electricity on a side that is of the middle frame and that is away from the display panel causes erratic display on the display panel.

With reference to the first aspect, in some implementations, the baffle is of a mesh structure. In this way, the electromagnetic wave signal is not emitted to the flexible printed circuit board through mesh holes. The baffle has a small weight, so that a weight of the foldable display module can be reduced.

With reference to the first aspect, in some implementations, a surface that is of the baffle and that is close to the antenna is closed, or a surface that is of the baffle and that is close to the flexible printed circuit board is closed. Therefore, blocking effect of the baffle is good, and the electromagnetic wave signal of the antenna cannot pass through the closed surface.

With reference to the first aspect, in some implementations, a size of the baffle is greater than a size of the flexible printed circuit board in a direction of a rotation axis of the first sub-frame. In this way, the baffle can prevent a signal of the antenna from being emitted to the flexible printed circuit board, thereby reducing the electromagnetic wave signal that passes through the flexible printed circuit board, and reducing the signal loss of the antenna.

With reference to the first aspect, in some implementations, the baffle extends from one end of the first sub-frame to the other end of the first sub-frame in the direction of the rotation axis of the first sub-frame. In this way, when the antenna is connected to any position of the end that is of the first sub-frame and that is close to the flexible printed circuit board, the baffle can block the electromagnetic wave signal emitted by the antenna to the flexible printed circuit board. A large margin is reserved for installation of the antenna. Even if an error exists in an installation size of the antenna, an electromagnetic wave emitted by the antenna toward the flexible printed circuit board may still be blocked by the baffle, so that assembly is simpler while the signal loss of the antenna is reduced.

With reference to the first aspect, in some implementations, the baffle includes a bent portion and a connection portion that are electrically connected to each other. The connection portion is electrically connected to the end that is of the first sub-frame and that is close to the flexible printed circuit board. The bent portion is bent toward the flexible printed circuit board, to enclose a surface that is of the flexible printed circuit board and that faces the antenna. Therefore, the bent portion has excellent blocking effect on the electromagnetic wave signal emitted by the antenna toward the flexible printed circuit board, so that under same blocking effect, space occupied by the baffle can be reduced, and other components of the foldable display device can be avoided.

With reference to the first aspect, in some implementations, a material of the baffle includes metal. The foregoing material has excellent conductivity, so that the baffle electrically connected to the first sub-frame can block an electromagnetic wave from passing through.

With reference to the first aspect, in some implementations, the baffle is welded to the end that is of the first sub-frame and that is close to the flexible printed circuit board; or the baffle and the end that is of the first sub-frame and that is close to the flexible printed circuit board are integrally formed. Therefore, the baffle and the first sub-frame are connected in a plurality of manners. The baffle may be prepared in a process of preparing the middle frame, or the baffle may be assembled with the prepared middle frame.

With reference to the first aspect, in some implementations, the first sub-frame includes a carrier board and a side board. The side board is disposed around a periphery of the carrier board, the carrier board and one end that is of the side board and that is close to the flexible printed circuit board are enclosed to form an accommodating groove, and the flexible printed circuit board is disposed in the accommodating groove. One end of the baffle is electrically connected to one end that is of the carrier board and that is close to the flexible printed circuit board, and the other end of the baffle extends toward the side board. Therefore, the accommodating groove provides installation space for the baffle, and existence of the baffle has little impact on a size of the foldable display module.

With reference to the first aspect, in some implementations, the first sub-frame further includes an insulation member. The insulation member is located in the accommodating groove, the side board and/or the carrier board are/is connected to the insulation member, and the baffle and the antenna are respectively located on two opposite sides of the insulation member. In this way, the insulation member may provide support strength for the side board and the baffle. In addition, existence of the insulation member does not affect a size of a clearance region of the antenna.

With reference to the first aspect, in some implementations, the baffle is connected to a surface that is of the first sub-frame and that faces the flexible printed circuit board. Therefore, space between the baffle and the antenna is large, and a large clearance region is provided for the antenna as much as possible.

According to a second aspect, a foldable display module is provided. The foldable display module includes a display panel, a flexible printed circuit board, a middle frame, an antenna, and a shield layer. The display panel is able to be folded in an S shape. The flexible printed circuit board is connected to one side of the display panel. The display panel and the flexible printed circuit board are arranged in a preset direction. The middle frame is connected to the display panel. The middle frame includes at least three sub-frames that are arranged in the preset direction and rotatably connected in sequence, and a sub-frame that is of the at least three sub-frames and that is closest to the flexible printed circuit board is a first sub-frame. The antenna is connected to one end that is of the first sub-frame and that is close to the flexible printed circuit board. The shield layer is connected to a surface of the flexible printed circuit board and is electrically connected to the end that is of the first sub-frame and that is close to the flexible printed circuit board, and an outer contour of a projection of the shield layer in a region of the antenna at least partially covers a projection of the flexible printed circuit board in region of the antenna. In this way, the shield layer may block an electromagnetic wave signal emitted by the antenna toward the flexible printed circuit board, and weaken an electromagnetic wave signal that passes through the flexible printed circuit board, so that a signal absorbed by the display panel is reduced, and a signal loss of the antenna is effectively improved.

With reference to the second aspect, in some implementations, a material of the shield layer includes metal. The foregoing material has excellent conductivity, so that the shield layer electrically connected to the first sub-frame can block an electromagnetic wave from passing through.

With reference to the second aspect, in some implementations, the shield layer is electrically connected, through a conductive adhesive, to the end that is of the first sub-frame and that is close to the flexible printed circuit board. In this way, the conductive adhesive may increase a contact area between the shield layer and the first sub-frame, and improve shielding effect of the shield layer. In addition, a connection manner and a process of the conductive adhesive are simple, and shapes of the shield layer and the first sub-frame are less limited.

According to a third aspect, a middle frame assembly is provided. The middle frame assembly is configured to connect to an antenna, a flexible printed circuit board, and a display panel. The middle frame assembly includes: at least three sub-frames, configured to connect to the display panel, to enable the display panel to be folded in an S shape, where the at least three sub-frames are arranged in a preset direction and rotatably connected in sequence, the preset direction is a direction in which the display panel and the flexible printed circuit board are arranged, and a sub-frame that is of the at least three sub-frames and that is located on an outermost side is a first sub-frame; and a baffle, electrically connected to one end that is of the first sub-frame and that is away from other sub-frames, where when the antenna, the flexible printed circuit board, and the display panel are connected to the middle frame, the antenna and the flexible printed circuit board are respectively located on two opposite sides of the baffle, and an outer contour of a projection of the baffle in a region of the antenna at least partially covers a projection of the flexible printed circuit board in region of the antenna. Therefore, after the middle frame assembly is connected to the antenna and the flexible printed circuit board, absorption of an electromagnetic wave signal of the antenna by the flexible printed circuit board can be effectively reduced, and a loss of the antenna can be reduced.

With reference to the third aspect, in some implementations, the baffle is of a mesh structure, or a surface of the baffle is closed.

With reference to the third aspect, in some implementations, the baffle extends from one end of the first sub-frame to the other end of the first sub-frame in a direction of a rotation axis of the first sub-frame.

With reference to the third aspect, in some implementations, the baffle includes a bent portion and a connection portion that are electrically connected to each other. The connection portion is electrically connected to the end that is of the first sub-frame and that is away from the other sub-frames. When the antenna and the display panel are both connected to the middle frame, the bent portion is bent toward the flexible printed circuit board, to enclose a surface that is of the flexible printed circuit board and that faces the antenna.

With reference to the third aspect, in some implementations, a material of the baffle includes metal.

With reference to the third aspect, in some implementations, the baffle is electrically connected and welded to the end that is of the first sub-frame and that is away from the other sub-frames; or the baffle and the end that is of the first sub-frame and that is away from the other sub-frames are integrally formed.

According to a fourth aspect, a foldable display device is provided. The foldable display device includes a rear housing and any foldable display module provided in the first aspect or the second aspect, and the rear housing is connected to a side that is of the middle frame and that is away from the display panel. Therefore, a loss of an electromagnetic wave of the antenna of the foldable display device is small.

### BRIEF DESCRIPTION OF DRAWINGS

FIG. 1a is a diagram of a structure of a foldable display device according to an embodiment of this application;
FIG. 1b is a diagram of a structure of the foldable display device in FIG. 1a in a folded state;
FIG. 2a is a diagram of a structure of a foldable display device in a related technology;
FIG. 2b is a cross-sectional diagram of a position N in FIG. 2a in a Z-Z direction;
FIG. 3a is a cross-sectional diagram of the foldable display device shown in FIG. 1b in an H-H direction;
FIG. 3b is an enlarged diagram of an internal structure of a foldable display device at a position C in FIG. 3a according to an embodiment of this application;
FIG. 4a is a diagram of structures of a first sub-frame and a baffle according to an embodiment of this application;
FIG. 4b is a diagram of cross-sectional structures of a first sub-frame and a baffle according to an embodiment of this application;
FIG. 4c is a diagram of structures of a baffle and a flexible printed circuit board according to an embodiment of this application;
FIG. 5 is an enlarged diagram of a position G in FIG. 3b;
FIG. 6a is a diagram of a structure of a baffle according to an embodiment of this application;
FIG. 6b is a diagram of another structure of a baffle according to an embodiment of this application;
FIG. 6c is a diagram of still another structure of a baffle according to an embodiment of this application;
FIG. 7a is an enlarged diagram of an internal structure of another foldable display device at a position C in FIG. 3a according to an embodiment of this application; and
FIG. 7b is an enlarged diagram of a position K in FIG. 7a.

In figures:
010: foldable display device; 011: first sub-frame; 001: side board; 002: carrier board; 003: display panel; 004: flexible printed circuit board; 005: bent region; 006: flat region; 012: second sub-frame; 013: third sub-frame; 014: flexible display; 015: rear housing; 017: antenna; 100: foldable display device; 103: first flat region; 104: second flat region; 105: third flat region; 101: first bent region; 102: second bent region; 110: flexible display; 111: display panel; 112: flexible printed circuit board; 120: middle frame; 121: first sub-frame; 122: second sub-frame; 123: third sub-frame; 124: carrier board; 125: side board; 126: accommodating groove; 127: insulation member; 130: rear housing; 140: antenna; 150: baffle; 151: bent portion; 152: connection portion; 153: base board; 160: spring sheet; 170: printed circuit board; 180: shield layer; 181: conductive adhesive.

### DESCRIPTION OF EMBODIMENTS

To make objectives, technical solutions, and advantages of this application clearer, the following further describes this application in detail with reference to the accompanying drawings.

The terms such as "first" and "second" below are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise specified, "a plurality of" means two or more.

In addition, in this application, orientation terms such as "upper", and "lower" are defined relative to illustrated orientations in which components in the accompanying drawings are placed. It should be understood that these directional terms are relative concepts and are used for description and clarification of relative positions, and may vary accordingly depending on a change in the orientations in which the components in the accompanying drawings are placed.

An embodiment of this application provides a foldable display device. The foldable display device may be a product that has a display interface, for example, a tablet computer, a mobile phone, an e-reader, a remote control, a personal computer (personal computer, PC), a notebook computer, a personal digital assistant (personal digital assistant, PDA), a vehicle-mounted device, a web television, a wearable device, or a television, and an intelligent display wearable product, for example, a smart watch or a smart band. A specific form of the electronic device is not specifically limited in embodiments of this application.

In this embodiment of this application, an example in which the foldable display device is a mobile phone is used for description.

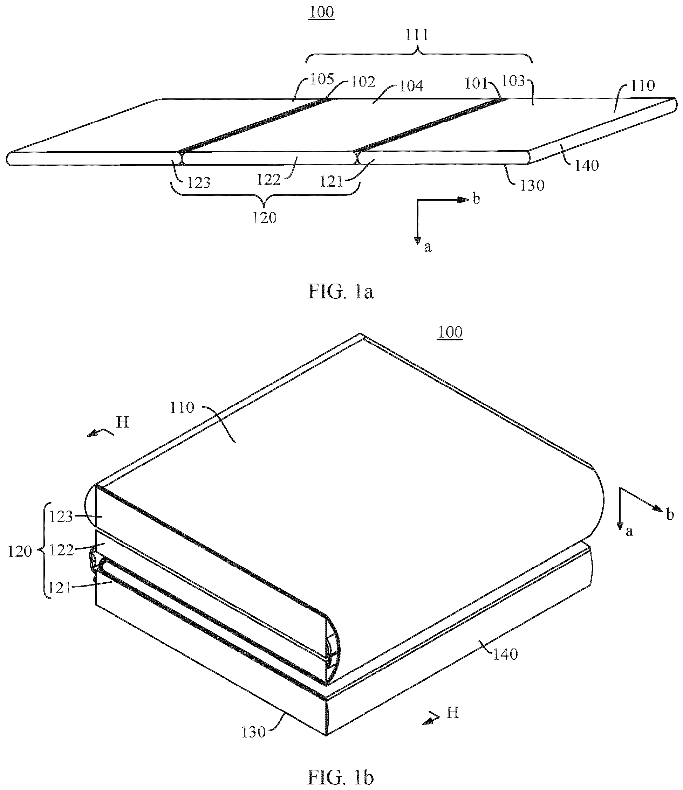

FIG. 1a is a diagram of a structure of a foldable display device 100 according to an embodiment of this application. Refer to FIG. 1a. The foldable display device 100 includes a flexible display 110, a middle frame 120, and a rear housing 130. The flexible display 110 and the rear housing 130 are respectively located on two opposite sides of the middle frame 120.

The middle frame 120 is grounded. For example, the middle frame 120 may be connected to a system ground.

The middle frame 120 includes a plurality of sub-frames, and the plurality of sub-frames are rotatably connected in sequence.

In some embodiments, the foldable display device 100 further includes electronic components such as a printed circuit board (printed circuit board, PCB), a battery, and a camera. The electronic components may be disposed on the middle frame 120.

For ease of description, a thickness direction of the foldable display device 100 is defined as a direction a. That is, the direction a is perpendicular to a surface of the flexible display 110 when the foldable display device is in a flattened state. When the flexible display 110 is in an unfolded state, an arrangement direction of the plurality of sub-frames is defined as a direction b. The direction a and the direction b are perpendicular to each other. In other words, a size of the flexible display 110 in the direction b changes before and after the flexible display 110 is folded.

The foldable display device 100 is an S-shaped foldable device. That is, after the foldable display device 100 is folded, the flexible display 110 extends along an S-shaped path.

FIG. 1b is a diagram of a structure of the foldable display device 100 in FIG. 1a in a folded state. Refer to FIG. 1b and FIG. 1a. Before and after the foldable display device 100 is folded, two opposite ends of the foldable display device 100 in the direction b are both exposed.

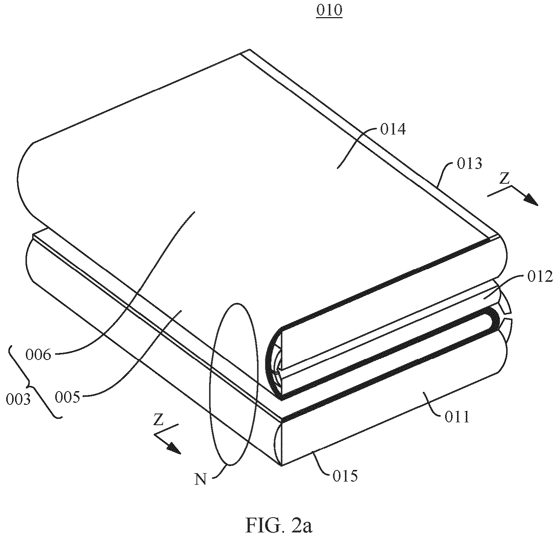

FIG. 2a is a diagram of a structure of a foldable display device 010 in a related technology. Refer to FIG. 2a. The foldable display device 010 includes a first sub-frame 011, a second sub-frame 012, a third sub-frame 013, a flexible display 014, and a rear housing 015. The first sub-frame 011, the second sub-frame 012, and the third sub-frame 013 are rotatably connected in sequence. The first sub-frame 011, the second sub-frame 012, and the third sub-frame 013 are all connected to the flexible display 014.

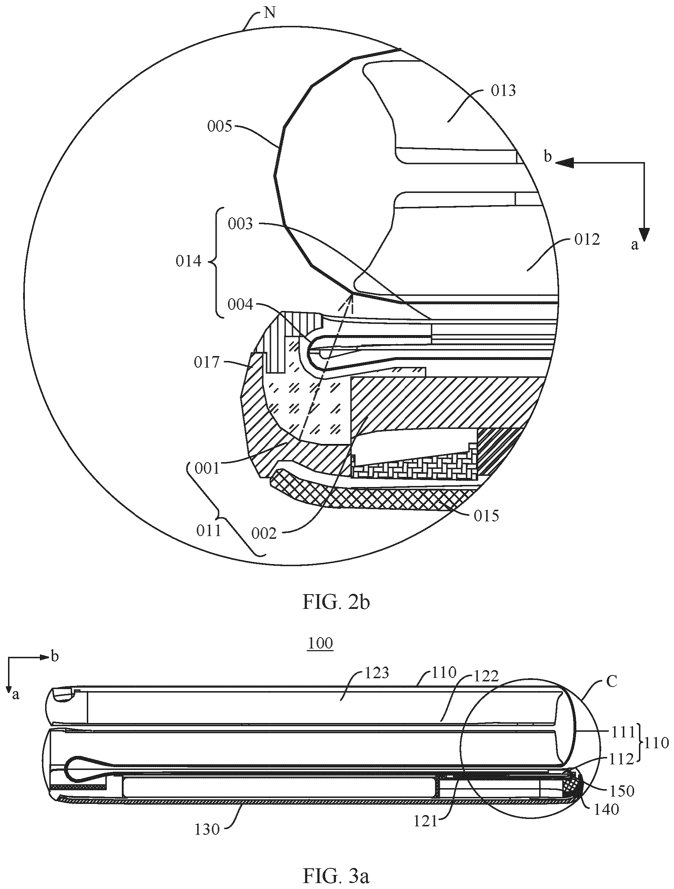

FIG. 2b is a cross-sectional diagram of a position N in FIG. 2a in a Z-Z direction. Refer to FIG. 2a and FIG. 2b together. FIG. 2b is a cross-sectional diagram of the position N in FIG. 2a. The foldable display device 010 may be folded or unfolded in a direction b. A thickness direction of the flexible display 014 is a direction a. A cross-section of the position N in FIG. 2b is parallel to the direction a and the direction b.

The first sub-frame 011 includes a side board 001 and a carrier board 002, and the side board 001 is disposed around a periphery of the carrier board 002. Two opposite sides of the carrier board 002 in the direction b are respectively connected to the flexible display 014 and the rear housing 015.

The foldable display device 010 further includes an antenna 017, and the antenna 017 is connected to the side board 001. In the example in FIG. 2b, a part of the side board 001 is the antenna 017.

The flexible display 014 includes a display panel 003 and a flexible printed circuit board (flexible printed circuit board, FPC for short) 004. A side of the display panel 003 in the direction b is electrically connected to the flexible printed circuit board 004.

The display panel 003 has two bent regions 005 and three flat regions 006, and two adjacent flat regions 006 are connected through one bent region 005. The three flat regions 006 are respectively connected to the first sub-frame 011, the second sub-frame 012, and the third sub-frame 013.

The foldable display device 010 may be folded in an S shape. After the foldable display device 010 is folded, one of the bent regions 005 is exposed on a surface, and a projection of the bent region 005 in a region of the antenna at least partially overlaps with a projection of the flexible printed circuit board 004 in the region of the antenna.

In FIG. 2b, an electromagnetic wave signal radiated by the antenna 017 passes through the flexible printed circuit board 004. A dashed arrow in FIG. 2b indicates a propagation direction of the electromagnetic wave signal that passes through the flexible printed circuit board 004. When the flexible display 014 is in a folded state, an electromagnetic wave that passes through the flexible printed circuit board 004 is emitted into the bent region 005 of the display panel 003. Because a light emitting layer of the display panel 003 includes a material having a high equivalent resistance, for example, an indium tin oxide (indium tin oxide, ITO), the material having the high equivalent resistance absorbs the electromagnetic wave signal radiated by the antenna 017, causing a loss of the electromagnetic wave signal.

Therefore, embodiments of this application provide the foldable display device 100. The foldable display device 100 can weaken an electromagnetic wave signal that is of an antenna and that passes through a flexible printed circuit board, thereby resolving a problem of a loss of the electromagnetic wave signal of the antenna.

A quantity of folds of the foldable display device 100 is not limited in embodiments of this application. For example, the foldable display device 100 has three folds, four folds, or more folds. In this embodiment of this application, an example in which the foldable display device 100 is a tri-fold device is used for description.

Refer to FIG. 1a again. The middle frame 120 is connected to the flexible display 110, the middle frame 120 includes a plurality of sub-frames (for example, 121, 122, and 123 in the figure), and the plurality of sub-frames are rotatably connected in sequence.

In this embodiment of this application, an example in which the foldable display device 100 is a tri-fold device is used, and there are three sub-frames. In an embodiment in which the foldable display device 100 is a four-fold device, there are four sub-frames. The rest may be deduced by analogy. Details are not described herein again.

In this embodiment of this application, as shown in FIG. 1a, the three sub-frames are respectively named as a first sub-frame 121, a second sub-frame 122, and a third sub-frame 123. In the direction b, two opposite ends of the second sub-frame 122 are respectively rotatably connected to the first sub-frame 121 and the third sub-frame 123. The first sub-frame 121, the second sub-frame 122, and the third sub-frame 123 are all connected to the flexible display 110.

The first sub-frame 121 is connected to the rear housing 130, the first sub-frame 121 and the rear housing 130 are enclosed to form an accommodating cavity, and electronic components such as a printed circuit board (printed circuit board, PCB), a battery, and a camera in the foldable display device 100 are accommodated in the accommodating cavity.

The flexible display 110 includes a display panel 111, and the display panel 111 includes three flat regions (103, 104, 105) and two bent regions (101, 102). Two adjacent flat regions are connected through one bent region. One flat region is connected to one sub-frame.

A flat region connected to the first sub-frame 121 is a first flat region 103. A flat region connected to the second sub-frame 122 is a second flat region 104. A flat region connected to the third sub-frame 123 is a third flat region 105.

The two bent regions are respectively named as a first bent region 101 and a second bent region 102. The first bent region 101 is located between the first flat region 103 and the second flat region 104. The second bent region 102 is located between the second flat region 104 and the third flat region 105.

Because the foldable display device 100 is an S-shaped foldable device, when the foldable display device 100 is in the folded state, the first bent region 101 is wrapped inside the foldable display device 100, and the second bent region 102 is exposed on a surface of the foldable display device 100. The first flat region 103 and the second flat region 104 are opposite to and close to each other.

The foldable display device 100 further includes an antenna 140, and the antenna 140 is disposed at one end that is of the first sub-frame 121 and that is away from the second sub-frame 122. For ease of description, the end that is of the first sub-frame 121 and that is away from the second sub-frame 122 is defined as a tail end of the first sub-frame 121.

In some embodiments of this application, the antenna 140 is a part of a conductor at the tail end of the first sub-frame 121.

Performance parameters such as a frequency, a gain, a standing wave ratio coefficient, a front-to-rear ratio, and power of the antenna 140 are not limited in embodiments of this application, and may be designed based on a requirement.

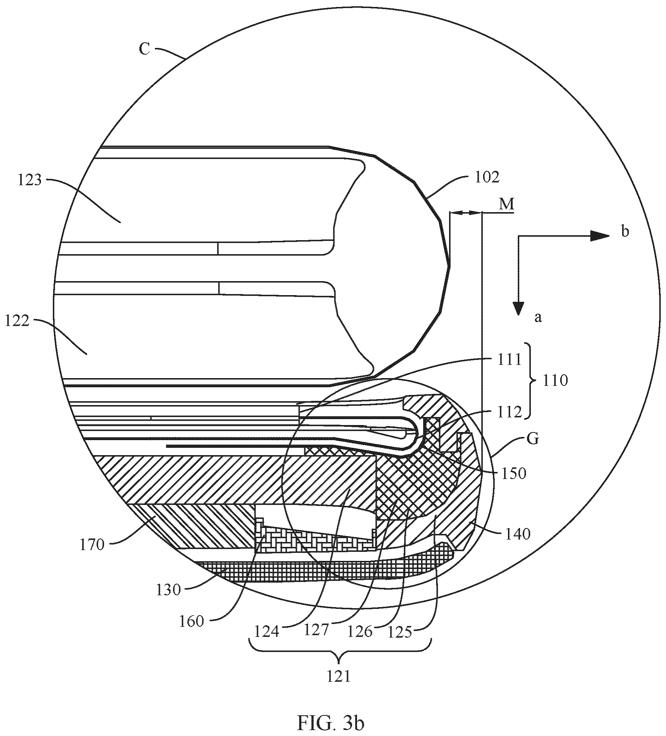

FIG. 3a is a cross-sectional diagram of the foldable display device 100 shown in FIG. 1b in an H-H direction. FIG. 3b is an enlarged diagram of an internal structure of the foldable display device 100 at a position C in FIG. 3a according to an embodiment of this application. Refer to both FIG. 3a and FIG. 3b. The foldable display device 100 further includes a baffle 150, and the baffle 150 is electrically connected to the tail end of the first sub-frame 121. The antenna 140 and the flexible display 110 are respectively located on two opposite sides of the baffle 150. In FIG. 3b, a cross section in which the antenna 140 is located is a cross section of an antenna radiator. A material of the baffle 150 is a conductive material. An electromagnetic wave emitted by the antenna 140 toward the flexible display 110 can be blocked by the baffle 150.

For example, the material of the baffle 150 includes a material having excellent conductivity, and an equivalent resistance of the material having the excellent conductivity is small, so that it is difficult for the electromagnetic wave of the antenna 140 to pass through the baffle 150.

For example, the material of the baffle 150 includes a metal material. For example, the metal material includes copper, gold, silver, nickel, aluminum, magnesium and alloys thereof, or stainless steel. The metal material has excellent conductivity and can block an electromagnetic wave from passing through. As shown in FIG. 3b, the flexible display 110 includes the display panel 111 and a flexible printed circuit board 112. A side that is of the display panel 111 and that is close to the tail end of the first sub-frame 121 is electrically connected to the flexible printed circuit board 112, and the flexible printed circuit board 112 is disposed close to the tail end of the first sub-frame 121.

In the first sub-frame 121, the second sub-frame 122, and the third sub-frame 123, the first sub-frame 121 is closest to the flexible printed circuit board 112, and the antenna 140 and the baffle 150 are both electrically connected to one end that is of the first sub-frame 121 and that is close to the flexible printed circuit board 112 (the tail end of the first sub-frame 121).

In other words, the antenna 140 and the baffle 150 are both connected to the tail end of the first sub-frame 121. The flexible printed circuit board 112 and the antenna 140 are respectively located on the two opposite sides of the baffle 150.

An outer contour of a projection of the baffle 150 in a region of the antenna 140 at least partially covers a projection of the flexible printed circuit board 112 in the region of the antenna 140. In this way, an electromagnetic wave emitted by the antenna 140 toward the flexible printed circuit board 112 is blocked by the baffle 150, and an electromagnetic wave signal that passes through the flexible printed circuit board 112 is weakened. Therefore, when the foldable display device 100 is in the folded state, an electromagnetic wave signal that passes through the flexible printed circuit board 112 and is emitted to the display panel 111 is reduced, and an electromagnetic wave signal absorbed by a material having a high equivalent resistance in the display panel 111 is reduced, so that a loss of the electromagnetic wave signal of the antenna 140 is reduced.

The foregoing material having the high equivalent resistance is, for example, an indium tin oxide (indium tin oxide, ITO).

The region of the antenna 140 is a projection on a surface of the antenna 140 in a propagation direction of the electromagnetic wave emitted by the antenna 140.

The outer contour of the projection of the baffle 150 in the region of the antenna 140 is an outer contour of a pattern of the projection of the baffle 150 in the region of the antenna 140.

That an outer contour of a projection of the baffle 150 in a region of the antenna 140 at least partially covers a projection of the flexible printed circuit board 112 in the region of the antenna 140 includes but is not limited to the following examples:
Example 1: A size of the baffle 150 is small, and the entire outer contour of the projection of the baffle 150 in the region of the antenna 140 is located within the projection of the flexible printed circuit board 112 in the region of the antenna 140. In this way, the baffle 150 may block some of electromagnetic waves emitted by the antenna 140 toward the flexible printed circuit board 112, and reduce electromagnetic wave signals absorbed by the display panel 111.
Example 2: A size of the baffle 150 is large, but a region enclosed by the outer contour of the projection of the baffle 150 in the region of the antenna 140 does not cover the entire projection of the flexible printed circuit board 112 in the region of the antenna 140. A part of the region enclosed by the outer contour of the projection of the baffle 150 in the region of the antenna 140 is located within the projection of the flexible printed circuit board 112 in the region of the antenna 140, and another part is located outside the projection of the flexible printed circuit board 112 in the region of the antenna 140. Similarly, the baffle 150 may block some of electromagnetic waves emitted by the antenna 140 toward the flexible printed circuit board 112, and reduce electromagnetic wave signals absorbed by the display panel 111.
Example 3: A size of the baffle 150 is large, and a region enclosed by the outer contour of the projection of the baffle 150 in the region of the antenna 140 covers the entire projection of the flexible printed circuit board 112 in the region of the antenna 140. Therefore, the baffle 150 may block almost all electromagnetic waves emitted by the antenna 140 toward the flexible printed circuit board 112, and almost no electromagnetic wave signal is absorbed by the display panel 111, so that the loss is further reduced.

Structures of the first sub-frame 121 and the baffle 150 are not limited in embodiments of this application, and are set based on a shape of the foldable display device 100 and a shape of the flexible printed circuit board 112.

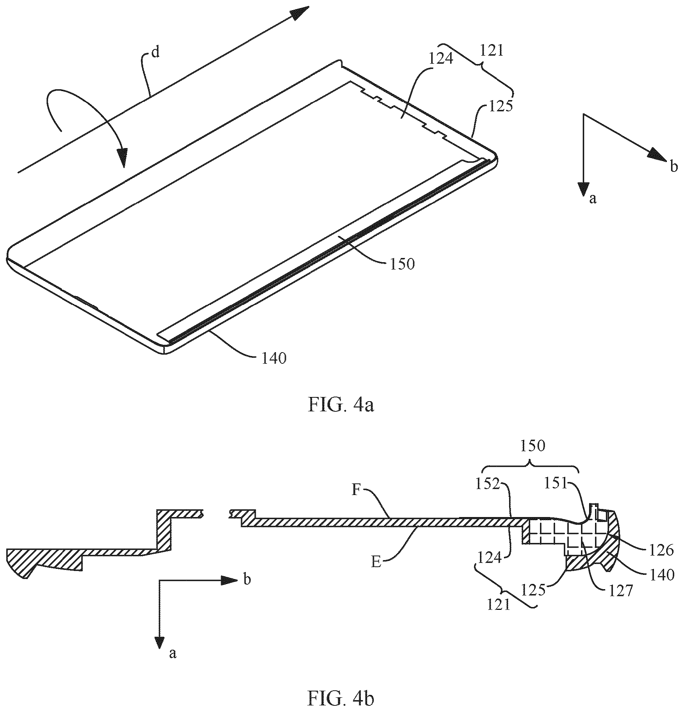

FIG. 4a is a diagram of structures of the first sub-frame 121 and the baffle 150 according to an embodiment of this application. Refer to FIG. 4a. The first sub-frame 121 includes a carrier board 124 and a side board 125. The side board 125 is connected to a periphery of the carrier board 124. The baffle 150 is electrically connected to one end that is of the carrier board 124 and that is close to the flexible printed circuit board 112. The antenna 140 is a part of the side board 125.

One end that is of the side board 125 and that is close to the second sub-frame 122 is rotatably connected to the second sub-frame 122. Alternatively, one end that is of the carrier board 124 and that is close to the second sub-frame 122 is rotatably connected to the second sub-frame 122.

A manner of connecting the baffle 150 to the flexible printed circuit board 112 is not limited in embodiments of this application. For example, the baffle 150 is not directly connected to the flexible printed circuit board 112, and there is a gap between the baffle 150 and the flexible printed circuit board 112. Alternatively, the baffle 150 is bonded to the flexible printed circuit board 112. Alternatively, a buffer material is disposed between the baffle 150 and the flexible printed circuit board 112, and the buffer material may be, for example, sponge.

A shape of the carrier board 124 is not limited in embodiments of this application. For example, a through hole may be provided on the carrier board 124, to avoid components such as a printed circuit board, a battery, and a camera.

As described above, the baffle 150 may block the electromagnetic wave emitted by the antenna 140 toward the flexible printed circuit board 112, and the carrier board 124 may also have a function of blocking the electromagnetic wave emitted by the antenna 140. Therefore, in some embodiments, the carrier board 124 may also block some electromagnetic waves emitted by the antenna 140 toward the flexible printed circuit board 112. It is clear that even if the region enclosed by the outer contour of the projection of the baffle 150 in the region of the antenna 140 covers only a part of the projection of the flexible printed circuit board 112 in the region of the antenna 140, the electromagnetic wave signal emitted by the antenna 140 toward the flexible printed circuit board 112 can be greatly blocked under auxiliary blocking effect of the carrier board 124 and the baffle 150.

As described above, the flexible printed circuit board 112 is connected to the side that is of the display panel 111 and that is close to the tail end of the first sub-frame 121. A region that is of the flexible printed circuit board 112 and that is close to the tail end of the first sub-frame 121 is a bent region, and the bent region is connected to the display panel 111.

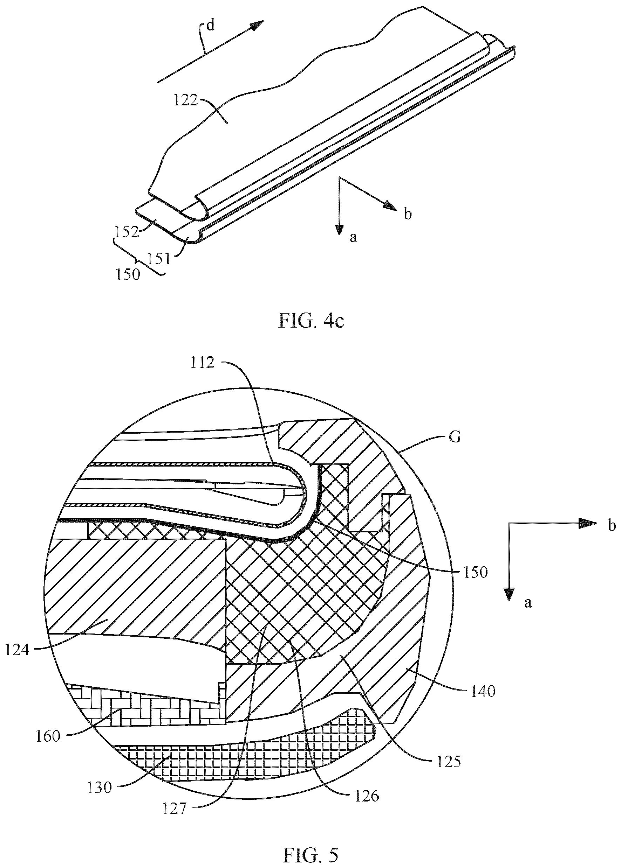

FIG. 5 is an enlarged diagram of a position G in FIG. 3b. Refer to FIG. 5. In FIG. 5, the tail end of the first sub-frame 121 has an accommodating groove 126, and the accommodating groove 126 is configured to accommodate the bent region that is of the flexible printed circuit board 112 and that is close to the tail end of the first sub-frame 121.

For example, the side board 125 and the carrier board 124 are enclosed to form the accommodating groove 126. In this way, the side board 125 and the carrier board 124 may avoid the flexible printed circuit board 112.

It may be understood that a size of the flexible printed circuit board 112 in the direction b is not limited in embodiments of this application. For example, in an embodiment in which a printed circuit board 170 is close to the side that is of the display panel 111 and that is close to the tail end of the first sub-frame 121, the size of the flexible printed circuit board 112 in the direction b may be small, and the entire flexible printed circuit board 112 may be located within the accommodating groove 126.

A shape of a cross section of the accommodating groove 126 is not limited in embodiments of this application, and the cross section is a plane perpendicular to both the direction b and the direction a. Cross sections of the accommodating groove 126 may be the same or different, and may be set based on structures of the side board 125 and the carrier board 124.

For example, in a region in which the side board 125 serves as the antenna 140, the carrier board 124 and the antenna 140 are spaced apart, and a shape of the accommodating groove 126 enclosed by the carrier board 124 and the antenna 140 is shown in FIG. 5.

In FIG. 5, the side board 125 serves as the antenna 140, the carrier board 124 is grounded, and there is a gap between the antenna 140 and the carrier board 124. Therefore, a region enclosed by the carrier board 124 and the side board 125 (the antenna 140) is a specially-shaped groove. The gap between the antenna 140 and the carrier board 124 is a part of the accommodating groove 126.

In FIG. 5, a region in which the accommodating groove 126 is located is a clearance region of the antenna 140. The electromagnetic wave emitted by the antenna 140 is propagated to the accommodating groove 126, and passes through the flexible printed circuit board 112 located in the accommodating groove 126.

One end of the baffle 150 is electrically connected to the carrier board 124, and the other end of the baffle 150 extends toward the antenna 140 (the side board 125). The baffle 150 covers the gap that is between the antenna 140 and the carrier board 124 and that is of the accommodating groove 126. The baffle 150 may block the electromagnetic wave emitted by the antenna 140 from passing through the gap, and block the electromagnetic wave from passing through the flexible printed circuit board 112.

As described above, the electromagnetic wave may be absorbed by the first bent region 101 after passing through the flexible printed circuit board 112. In this way, the baffle 150 can prevent the electromagnetic wave from being absorbed by the first bent region 101, and reduce a signal loss of the antenna 140.

Because the baffle 150 is electrically connected to the carrier board 124, a region enclosed by the antenna 140, the baffle 150, and the carrier board 124 is a clearance region of the antenna 140. A size of the gap between the antenna 140 and the carrier board 124 directly affects a size of the clearance region of the antenna 140.

A shape of the gap is not limited in embodiments of this application, and may be set based on mechanical performance, processing costs, and the like of the first sub-frame 121.

On the basis of meeting mechanical performance and electrical performance of the foldable electronic device 100, a size of gap space can be increased. This helps improve a bandwidth and efficiency of the antenna 140. When the gap increases, power of an electromagnetic wave that passes through the flexible printed circuit board 112 increases, and the signal loss of the antenna may increase. Disposition of the baffle 150 may avoid a signal loss, caused by an increase of the gap, of the antenna.

For example, the baffle 150 may cover the entire gap between the antenna 140 and the carrier board 124. In this way, the baffle 150 can greatly block the electromagnetic wave from passing through the flexible printed circuit board 112.

Alternatively, in some embodiments, the baffle 150 may cover only a part of a region of the gap, and the baffle 150 can still block the electromagnetic wave from passing through the flexible printed circuit board 112.

In a region in which the side board 125 does not serve as the antenna 140, a shape of the accommodating groove 126 is not limited in embodiments of this application. For example, the accommodating groove 126 may be in a shape shown in FIG. 5, or may be in another shape.

In this embodiment of this application, one end that is of the baffle 150 and that is away from the carrier board 124 is spaced apart from the side board 125. A distance between the baffle 150 and the side board 125 is not limited in embodiments of this application. In other words, in the direction b, the distance between the baffle 150 and the side board 125 is not limited in embodiments of this application. Debugging may be performed based on a performance requirement of the antenna 140.

In some embodiments of this application, the first sub-frame 121 further includes an insulation member 127, the insulation member 127 is located in the accommodating groove 126, and the antenna 140 and the baffle 150 are both connected to the insulation member 127. The insulation member 127 has a function of supporting the antenna 140 and the baffle 150, to avoid deformation of the antenna 140 after a force is applied, and increase mechanical performance of the first sub-frame 121. In addition, the insulation member 127 does not change the size of the clearance region of the antenna 140.

A material of the insulation member 127 is not limited in embodiments of this application. For example, the material of the insulation member 127 may be plastic, rubber, or the like.

FIG. 4b is a diagram of cross-sectional structures of the first sub-frame 121 and the baffle 150 according to an embodiment of this application. In FIG. 4b, the antenna 140 is a part of the side board 125, and a cross section of the antenna 140 and a cross section of the side board 125 are a same cross section.

In FIG. 4b, in the direction a, the carrier board 124 has a surface F and a surface E that are opposite to each other. The surface F faces the display panel 111, and the surface E is away from the display panel 111. In the direction a, a distance from the surface F to the antenna 140 is greater than a distance from the surface E to the antenna 140.

In some embodiments of this application, as shown in FIG. 4b, the baffle 150 is connected to the surface F. In other words, a distance from the baffle 150 to the surface F is less than a distance from the baffle 150 to the surface E.

In some other embodiments of this application, the baffle 150 may alternatively be connected to a side that is of the carrier board 124 and that is close to the antenna 140. In other words, a distance from the baffle 150 to the surface F is greater than a distance from the baffle 150 to the surface E.

Compared with the embodiment in which the baffle 150 is connected to the side that is of the carrier board 124 and that is close to the antenna 140, in an embodiment in which the baffle 150 is connected to a side that is of the carrier board 124 and that is away from the antenna 140, a distance between the baffle 150 and the antenna 140 in the direction a includes a thickness of the carrier board 124 in the direction a, space between the baffle 150 and the antenna 140 is large, and the clearance region between the baffle 150 and the antenna 140 is large. This can improve the bandwidth and the efficiency of the antenna 140.

A size of the baffle 150 is not limited in embodiments of this application, and the size is related to a size of the flexible printed circuit board 112.

Refer to FIG. 4a again. The first sub-frame 121 may rotate relative to the second sub-frame 122 in a direction of a rotation axis, so that the foldable display device 100 is folded or unfolded. The direction of the rotation axis is defined as a direction d, and a size of the baffle 150 in the direction d is greater than a size of the flexible printed circuit board 112 in the direction d.

FIG. 4c is a diagram of structures of the baffle 150 and the flexible printed circuit board 112 according to an embodiment of this application. Refer to FIG. 4c. The size of the baffle 150 in the direction d is greater than the size of the flexible printed circuit board 112 in the direction d.

In this way, the baffle 150 electrically connected to the carrier board 124 can greatly block the electromagnetic wave emitted by the antenna 140 toward the flexible printed circuit board 112.

Further, in some embodiments, the baffle 150 extends from one end of the first sub-frame 121 to the other end of the first sub-frame 121 in the direction d. Therefore, the baffle 150 can better block the electromagnetic wave emitted by the antenna 140 toward the flexible printed circuit board 112. In addition, the antenna 140 is connected to any position of the side board 125 in the direction d. The electromagnetic wave emitted by the antenna 140 toward the flexible printed circuit board 112 may be blocked by the baffle 150, and a large margin is reserved for installation of the antenna 140. Even if an error exists in an installation size of the antenna 140, the electromagnetic wave emitted by the antenna 140 toward the flexible printed circuit board 112 may still be blocked by the baffle 150, so that assembly is simpler while the signal loss of the antenna is reduced.

A shape of an outer contour of the baffle 150 is not limited in embodiments of this application, and may be limited based on a shape of an opening that is of the accommodating groove 126 between the carrier board 124 and the side board 125 and that faces one side of the flexible printed circuit board 112.

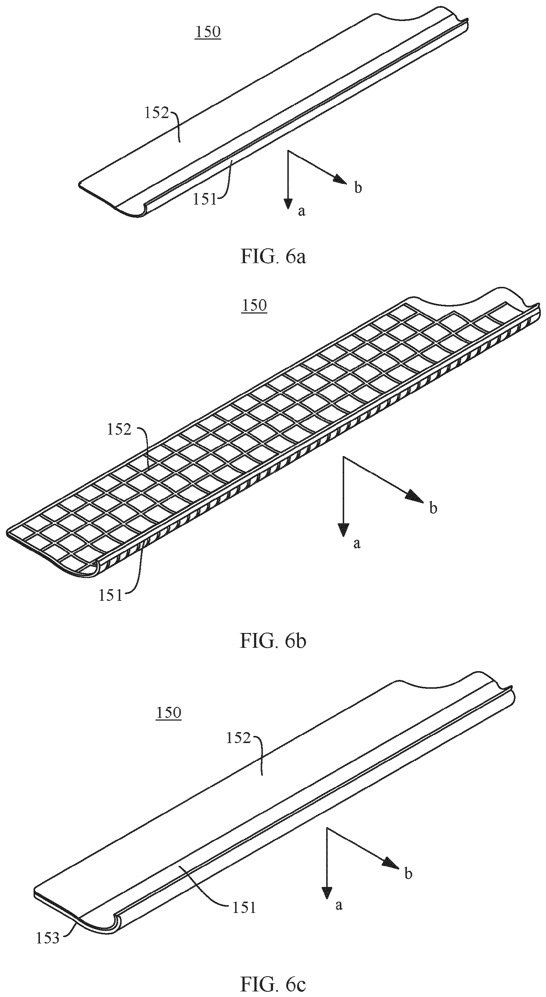

FIG. 6a is a diagram of a structure of the baffle 150 according to an embodiment of this application. Refer to FIG. 6a and FIG. 4b together. The baffle 150 includes a bent portion 151 and a connection portion 152, and the bent portion 151 is electrically connected to the connection portion 152.

The connection portion 152 is connected to the tail end of the first sub-frame 121, and the bent portion 151 is bent toward the flexible printed circuit board 112, to enclose a surface that is of the flexible printed circuit board 112 and that faces the antenna 140. Therefore, the bent portion 151 has excellent blocking effect on the electromagnetic wave emitted by the antenna 140 toward the flexible printed circuit board 112, so that under same blocking effect, space occupied by the baffle 150 can be reduced, and other components of the foldable display device 100 can be avoided.

A shape of the bent portion 151 is not limited in embodiments of this application. For example, a cross section of the bent portion 151 may be arc-shaped, or a cross section of the bent portion 151 may be L-shaped. The foregoing cross section is parallel to both the direction a and the direction b.

In another embodiment of this application, the baffle 150 may be in another shape. For example, the bent portion 151 may be replaced with a straight board, a bent board that is bent away from the flexible printed circuit board 112, a specially-shaped board, or a board in another shape, and may be set based on a shape of space for accommodating the baffle 150 at the tail end of the first sub-frame 121.

A shape of the connection portion 152 is not limited in embodiments of this application, and may be set based on a manner of connecting the connection portion 152 to the tail end of the first sub-frame 121 and a shape of space for accommodating the connection portion 152.

A manner of electrically connecting the connection portion 152 to the tail end of the first sub-frame 121 is not limited in embodiments of this application. For example, the connection portion 152 is welded to the tail end of the first sub-frame 121, or the connection portion 152 is bonded to the tail end of the first sub-frame 121 through a conductive adhesive, or the connection portion 152 and the first sub-frame 121 are integrally formed.

In an embodiment in which the connection portion 152 and the first sub-frame 121 are integrally formed, the connection portion 152 may be considered as a part of the carrier board 124, and the bent portion 151 may also be considered as a component that is of the carrier board 124 and that extends into a part between the flexible printed circuit board 112 and the antenna 140.

As described above, the material of the baffle 150 is a conductive material. In some embodiments of this application, the baffle 150 may include a plurality of materials, and may be set based on a manner of connecting the baffle 150 to the first sub-frame 121, or the like.

A material of the bent portion 151 is the same as a material of the connection portion 152. Alternatively, a material of the bent portion 151 is different from a material of the connection portion 152.

For example, in an embodiment in which the baffle 150 is welded to the first sub-frame 121, to ensure good mechanical performance of a welding spot, the connection portion 152 may use a material having a melting point close to that of the first sub-frame 121, and selection of a material of the bent portion 151 may not be limited thereto. In this way, the material of the bent portion 151 may be different from the material of the connection portion 152.

As described above, the outer contour of the projection of the baffle 150 in the region of the antenna 140 at least partially covers the projection of the flexible printed circuit board 112 in the region of the antenna 140. An internal shape of the projection of the baffle 150 in the region of the antenna 140 is not limited in embodiments of this application.

In FIG. 6a, the baffle 150 is of a closed structure. In other words, no through hole is provided on the baffle 150, a surface that is of the baffle 150 and that faces the flexible printed circuit board 112 is a closed surface, and a surface that is of the baffle 150 and that faces the antenna 140 is also a closed surface. The projection of the baffle 150 in the region of the antenna 140 is a closed shadow region. The baffle 150 has excellent blocking effect on the electromagnetic wave emitted by the antenna 140 toward the flexible printed circuit board 112.

FIG. 6b is a diagram of another structure of the baffle 150 according to an embodiment of this application. Refer to FIG. 6b. The baffle 150 is of a mesh structure, and an internal shape of the projection of the baffle 150 in the region of the antenna 140 is a mesh. The baffle 150 also has blocking effect on the electromagnetic wave emitted by the antenna 140 toward the flexible printed circuit board 112. In addition, a weight of the baffle 150 can be reduced, so that a weight of the foldable display device 100 is reduced.

A size of mesh holes on the baffle 150 is not limited in embodiments of this application, and may be set based on a performance parameter of the antenna 140.

In some embodiments, the size of the mesh holes on the baffle 150 is less than or equal to one-tenth of a wavelength of the antenna 140 in an operating frequency band. In this way, the baffle 150 also has excellent blocking effect on the electromagnetic wave emitted by the antenna 140 toward the flexible printed circuit board 112.

The foregoing size of the mesh holes is a maximum size of the mesh holes in a propagation direction of the electromagnetic wave emitted by the antenna 140 toward the flexible printed circuit board 112.

It may be understood that, in some embodiments, to facilitate the connection between the connection portion 152 of the baffle 150 and the first sub-frame 121, the connection portion 152 may be of a closed board-shaped structure, and the bent portion 151 may be of a mesh structure. This is not limited in embodiments of this application.

It may be understood that in some embodiments of this application, the baffle 150 may not be of a mesh structure. For example, the baffle 150 may have holes, and the holes may avoid other components of the foldable display device 100. A shape and a quantity of holes are not limited.

FIG. 6c is a diagram of still another structure of the baffle 150 according to an embodiment of this application. Refer to FIG. 6c. In FIG. 6c, the baffle 150 includes a base board 153, the connection portion 152, and the bent portion 151. The connection portion 152 is electrically connected to the bent portion 151, and the connection portion 152 and the bent portion 151 are both connected to one side of the base board 153.

The base board 153 may support the connection portion 152 and the bent portion 151. In an embodiment in which a material of the connection portion 152 and a material of the bent portion 151 are soft materials such as copper, the base board 153 may improve mechanical performance of the baffle 150.

A material of the base board 153 is not limited in embodiments of this application. The material of the base board 153 may be a conductive material or may be an insulation material. For example, the material of the base board 153 may be plastic having a low density and high mechanical strength, or the base board 153 may be steel.

A shape of the base board 153 is not limited in embodiments of this application. For example, the base board 153 may be a closed board, or may be of a mesh structure.

A manner of connecting the base board 153 to the connection portion 152 and a manner of connecting the base board 153 to the bent portion 151 are not limited in embodiments of this application. For example, a manner of bonding may be used.

As described above, a rotation joint between the second sub-frame 122 and the third sub-frame 123 is connected to the second bent region 102.

When the foldable display device 100 is in the folded state, the second bent region 102 is bent toward the middle frame 120, and the second bent region 102 is exposed on a surface. The second bent region 102 is close to the tail end of the first sub-frame 121, and a projection of the second bent region 102 in the region of the antenna overlaps with the projection of the flexible printed circuit board 112 in the region of the antenna.

Therefore, the electromagnetic wave emitted by the antenna 140 is almost not emitted from a region outside the flexible printed circuit board 112 to the second bent region 102, and a probability that the electromagnetic wave is absorbed by the second bent region 102 is low.

A distance between a tail end of the antenna 140 and a tail end of the second bent region 102 is not limited in embodiments of this application. The tail end of the antenna 140 is a farthest end of the antenna 140 in the direction b, and the tail end of the second bent region 102 is a farthest end of the second bent region 102 in the direction b.

For example, when the foldable display device 100 is in the folded state, the distance M between the tail end of the antenna 140 and the tail end of the second bent region 102 ranges from 0 mm to 6 mm in the direction b. For example, the distance M may be 0 mm, 1 mm, 2 mm, 3 mm, 3 mm, 4 mm, 5 mm, 6 mm, or the like. In this way, the electromagnetic wave emitted by the antenna 140 may be prevented from bypassing the side board 125 from a side that is of the side board 125 and that is away from the carrier board 124 and being emitted to the second bent region 102 and absorbed by the second bent region 102. This helps reduce a loss of the antenna 140.

Still refer to FIG. 3b. In some embodiments of this application, the foldable display device 100 may further include a spring sheet 160, and the printed circuit board 170 feeds power to the antenna 140 through the spring sheet 160.

When the foldable display device 100 is in the folded state, the electromagnetic wave signal that passes through the flexible printed circuit board 112 is absorbed by the display panel 111 connected to the second sub-frame 122, causing a loss. The baffle 150 shown in FIG. 3a and FIG. 3b may block the electromagnetic wave signal emitted by the antenna 140 toward the flexible printed circuit board 112, so that a signal absorbed by the display panel 111 is reduced, and a signal loss of the antenna 140 is reduced. In addition, the baffle 150 may block a charge (for example, static electricity) on one side of the rear housing 130 from being transferred to the flexible display 110, thereby resolving a problem of erratic display occurred when the flexible display 110 is hit by static electricity.

In some embodiments of this application, the electromagnetic wave signal emitted by the antenna 140 toward the flexible printed circuit board 112 may alternatively be blocked in another manner.

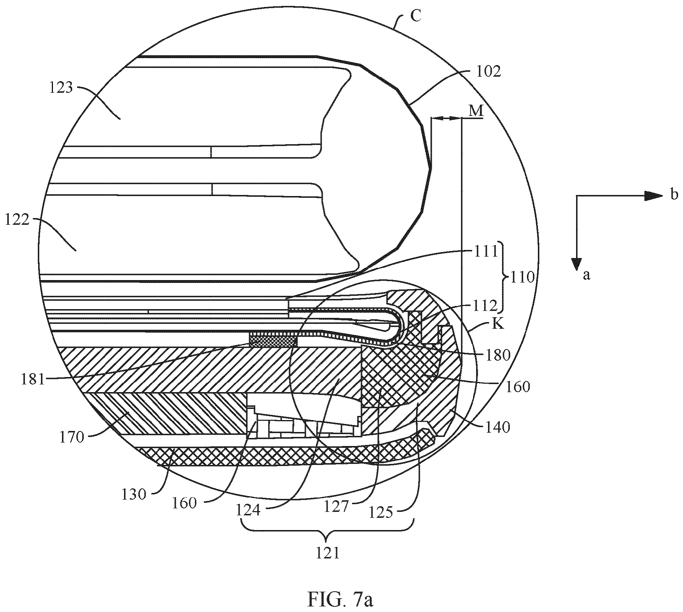

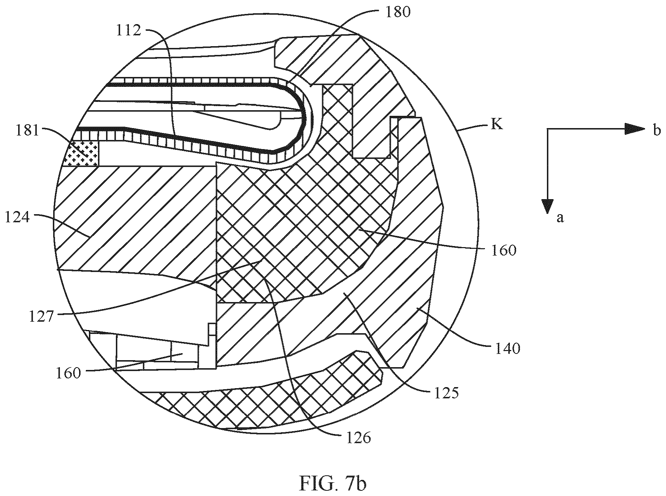

FIG. 7a is an enlarged diagram of an internal structure of another foldable display device 100 at the position C in FIG. 3a according to an embodiment of this application. FIG. 7b is an enlarged diagram of a position K in FIG. 7a. Refer to FIG. 7a and FIG. 7b. The foldable display device 100 further includes a shield layer 180, and no baffle 150 is disposed on the foldable display device 100. For other structures, refer to related descriptions in FIG. 1a, FIG. 1b, FIG. 3a, and FIG. 3b. Details are not described herein again.

In FIG. 7b, the shield layer 180 is connected to a surface of a flexible printed circuit board 112, and the shield layer 180 is electrically connected to a tail end of a first sub-frame 121. An outer contour of a projection of the shield layer 180 in a region of an antenna 140 at least partially covers a projection of the flexible printed circuit board 112 in the region of the antenna 140.

In this way, the shield layer 180 may block an electromagnetic wave signal emitted by the antenna 140 toward the flexible printed circuit board 112, and when the foldable display device 100 is in a folded state, an electromagnetic wave signal that passes through the flexible printed circuit board 112 and is absorbed by a display panel 111 is reduced, so that a signal loss of the antenna 140 is reduced.

Similarly, in this embodiment of this application, there may also be a plurality of examples of the outer contour of the projection of the shield layer 180 in the region of the antenna 140 and the projection of the flexible printed circuit board 112 in the region of the antenna 140. This is similar to the outer contour of the projection of the baffle 150 in the region of the antenna 140. Details are not described herein again.

In some embodiments, the shield layer 180 may cover an entire surface that is of the flexible printed circuit board 112 and that faces the antenna 140. In this way, in a process of connecting the flexible printed circuit board 112 and the antenna 140, the flexible printed circuit board 112 and the antenna 140 may have a plurality of location relationships, and an allowed installation error is large.

Alternatively, in some embodiments, the shield layer 180 may cover only a region that is of the flexible printed circuit board 112 and that can be radiated by an electromagnetic wave of the antenna 140. A material used for the shield layer 180 can be saved.

A material of the shield layer 180 is a conductive material. For example, the shield layer 180 includes a material having good conductivity. For example, the material of the shield layer 180 includes a metal material. For example, the metal material includes copper, gold, silver, nickel, aluminum, magnesium and alloys thereof, or stainless steel. The metal material has excellent conductivity and can block an electromagnetic wave from passing through.

It may be understood that, in some embodiments, the shield layer 180 further includes a material having good support performance. For example, the shield layer 180 is formed by overlapping a plurality of layers of laminated structures. A material of some laminated structures is a materials having good conductivity, and can provide a good function of blocking an electromagnetic wave signal. A material of some laminated structure is a material having good support performance, and can provide good support. The support performance is not limited by the conductivity, and a material having good support performance but poor conductivity may be selected.

A manner of electrically connecting the shield layer 180 to the first sub-frame 121 is not limited in embodiments of this application.

In some embodiments of this application, the shield layer 180 is connected to the first sub-frame 121 through a conductive adhesive 181. A contact area between the shield layer 180 and the first sub-frame 121 can be increased, and shielding effect of the shield layer 180 can be improved. In addition, a connection manner of the conductive adhesive 181 is simple, and few limitations are imposed on shapes of the shield layer 180 and the first sub-frame 121.

In some other embodiments of this application, the shield layer 180 is welded to the first sub-frame 121.

A shape of the shield layer 180 is not limited in embodiments of this application. In some embodiments of this application, the shield layer 180 is of a mesh structure.

A size of mesh holes of the shield layer 180 is not limited, and may be set based on a performance parameter of the antenna 140. For example, the size of the mesh holes of the shield layer 180 is less than or equal to one-tenth of a wavelength of the antenna 140 in an operating frequency band. In this way, the shield layer 180 also has excellent blocking effect on the electromagnetic wave emitted by the antenna 140 toward the flexible printed circuit board 112.

The foregoing size of the mesh holes is a maximum size of the mesh holes in a propagation direction of the electromagnetic wave emitted by the antenna 140 toward the flexible printed circuit board 112.

In some other embodiments, the shield layer 180 is of a closed structure, no hole structure is disposed in the shield layer 180, and the shield layer 180 has excellent shielding effect.

A manner of connecting the shield layer 180 to the flexible printed circuit board 112 is not limited in embodiments of this application. For example, the shield layer 180 is bonded to the flexible printed circuit board 112. Alternatively, the shield layer 180 is formed on the surface of the flexible printed circuit board 112 in a coating manner.

A manner of connecting the shield layer 180 to an insulation member 127 is not limited in embodiments of this application. In some embodiments, the shield layer 180 is not directly connected to the insulation member 127, and there is a gap between the shield layer 180 and the insulation member 127. In some embodiments, the shield layer 180 may alternatively abut against the insulation member 127.

Refer to FIG. 7a again. When the foldable display device 100 shown in FIG. 7a is in the folded state, under shielding effect of the shield layer 180, an electromagnetic wave signal that passes through the flexible printed circuit board 112 is weak, and an electromagnetic wave signal absorbed by the display panel 111 is reduced. This reduces the signal loss of the antenna 140.

Refer to FIG. 7a and FIG. 3b together. In some embodiments, the foldable display device 100 may include the baffle 150 in FIG. 3b and the shield layer 180 in FIG. 7a, to further improve blocking effect on the electromagnetic wave signal emitted by the antenna 140 toward the flexible printed circuit board 112.

In an embodiment in which the foldable display device 100 includes the baffle 150 and the shield layer 180, the shield layer 180 is electrically connected to the baffle 150. Alternatively, the shield layer 180 is electrically connected to the first sub-frame 121. This is not limited in embodiments of this application.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A foldable display module, comprising:
a display panel, wherein the display panel is able to be folded in an S shape;
a flexible printed circuit board, connected to one side of the display panel, wherein the display panel and the flexible printed circuit board are arranged in a preset direction;
a middle frame, connected to the display panel, wherein the middle frame comprises at least three sub-frames that are arranged in the preset direction and rotatably connected in sequence, and a sub-frame that is of the at least three sub-frames and that is closest to the flexible printed circuit board is a first sub-frame;
an antenna, connected to one end that is of the first sub-frame and that is close to the flexible printed circuit board; and
a baffle, electrically connected to the end that is of the first sub-frame and that is close to the flexible printed circuit board, wherein
the antenna and the flexible printed circuit board are respectively located on two opposite sides of the baffle, and an outer contour of a projection of the baffle in a region of the antenna at least partially covers a projection of the flexible printed circuit board in the region of the antenna.

2. The foldable display module according to claim 1, wherein the baffle is of a mesh structure.

3. The foldable display module according to claim 1, wherein a surface that is of the baffle and that is close to the antenna is closed, or a surface that is of the baffle and that is close to the flexible printed circuit board is closed.

4. The foldable display module according to any one of claims 1 to 3, wherein a size of the baffle is greater than a size of the flexible printed circuit board in a direction of a rotation axis of the first sub-frame.

5. The foldable display module according to any one of claims 1 to 4, wherein the baffle extends from one end of the first sub-frame to the other end of the first sub-frame in the direction of the rotation axis of the first sub-frame.

6. The foldable display module according to any one of claims 1 to 5, wherein the baffle comprises a bent portion and a connection portion that are electrically connected to each other, the connection portion is electrically connected to the end that is of the first sub-frame and that is close to the flexible printed circuit board, and the bent portion is bent toward the flexible printed circuit board, to enclose a surface that is of the flexible printed circuit board and that faces the antenna.

7. The foldable display module according to any one of claims 1 to 6, wherein a material of the baffle comprises metal.

8. The foldable display module according to any one of claims 1 to 7, wherein the baffle is welded to the end that is of the first sub-frame and that is close to the flexible printed circuit board; or
the baffle and the end that is of the first sub-frame and that is close to the flexible printed circuit board are integrally formed.

9. The foldable display module according to any one of claims 1 to 8, wherein the first sub-frame comprises a carrier board and a side board, the side board is disposed around a periphery of the carrier board, the carrier board and one end that is of the side board and that is close to the flexible printed circuit board are enclosed to form an accommodating groove, the flexible printed circuit board is disposed in the accommodating groove, one end of the baffle is electrically connected to one end that is of the carrier board and that is close to the flexible printed circuit board, and the other end of the baffle extends toward the side board.

10. The foldable display module according to claim 9, wherein the first sub-frame further comprises an insulation member, the insulation member is located in the accommodating groove, the side board and/or the carrier board are/is connected to the insulation member, and the baffle and the antenna are respectively located on two opposite sides of the insulation member.

11. The foldable display module according to any one of claims 1 to 10, wherein the baffle is connected to a surface that is of the first sub-frame and that faces the flexible printed circuit board.

12. A foldable display module, wherein the foldable display module comprises:
a display panel, wherein the display panel is able to be folded in an S shape;
a flexible printed circuit board, connected to one side of the display panel, wherein the display panel and the flexible printed circuit board are arranged in a preset direction;
a middle frame, connected to the display panel, wherein the middle frame comprises at least three sub-frames that are arranged in the preset direction and rotatably connected in sequence, and a sub-frame that is of the at least three sub-frames and that is closest to the flexible printed circuit board is a first sub-frame;
an antenna, connected to one end that is of the first sub-frame and that is close to the flexible printed circuit board; and
a shield layer, connected to a surface of the flexible printed circuit board, and electrically connected to the end that is of the first sub-frame and that is close to the flexible printed circuit board, wherein
an outer contour of a projection of the shield layer in a region of the antenna at least partially covers a projection of the flexible printed circuit board in the region of the antenna.

13. The foldable display module according to claim 12, wherein a material of the shield layer comprises metal.

14. The foldable display module according to claim 13, wherein the shield layer is electrically connected, through a conductive adhesive, to the end that is of the first sub-frame and that is close to the flexible printed circuit board.

15. A middle frame assembly, wherein the middle frame assembly is configured to connect to an antenna, a flexible printed circuit board, and a display panel, and the middle frame assembly comprises:
at least three sub-frames, configured to connect to the display panel, to enable the display panel to be folded in an S shape, wherein the at least three sub-frames are arranged in a preset direction and rotatably connected in sequence, the preset direction is an arrangement direction of the display panel and the flexible printed circuit board, and a sub-frame that is of the at least three sub-frames and that is located on an outermost side is a first sub-frame; and
a baffle, electrically connected to one end that is of the first sub-frame and that is away from other sub-frames, wherein
when the antenna, the flexible printed circuit board, and the display panel are connected to the middle frame, the antenna and the flexible printed circuit board are respectively located on two opposite sides of the baffle, and an outer contour of a projection of the baffle in a region of the antenna at least partially covers a projection of the flexible printed circuit board in the region of the antenna.

16. The middle frame assembly according to claim 15, wherein the baffle is of a mesh structure, or a surface of the baffle is closed.

17. The middle frame assembly according to claim 15 or 16, wherein the baffle extends from one end of the first sub-frame to the other end of the first sub-frame in a direction of a rotation axis of the first sub-frame.

18. The middle frame assembly according to any one of claims 15 to 17, wherein the baffle comprises a bent portion and a connection portion that are electrically connected to each other, the connection portion is electrically connected to the end that is of the first sub-frame and that is away from the other sub-frames, and when the antenna and the display panel are both connected to the middle frame, the bent portion is bent toward the flexible printed circuit board, to enclose a surface that is of the flexible printed circuit board and that faces the antenna.

19. The middle frame assembly according to any one of claims 15 to 18, wherein a material of the baffle comprises metal.

20. The middle frame assembly according to any one of claims 15 to 19, wherein the baffle is electrically connected and welded to the end that is of the first sub-frame and that is away from the other sub-frames; or
the baffle and the end that is of the first sub-frame and that is away from the other sub-frames are integrally formed.

21. A foldable display device, wherein the foldable display device comprises a rear housing and the foldable display module according to any one of claims 1 to 14, and the rear housing is connected to a side that is of the middle frame and that is away from the display panel.
